Europäisches Patentamt

European Patent Office

Office européen des brevets

(19)

(11) Publication number: **0 004 164**
**B1**

(12) **EUROPEAN PATENT SPECIFICATION**

(45) Date of publication of patent specification: **17.11.82**

(21) Application number: **79300315.3**

(22) Date of filing: **01.03.79**

(51) Int. Cl.³: **H 01 L 39/24,**
**H 01 L 21/74, H 01 L 21/90**

(54) Method of making interlayer electrical connections in a multilayer electrical device.

(30) Priority: **02.03.78 US 882826**

(43) Date of publication of application:
**19.09.79 Bulletin 79/19**

(45) Publication of the grant of the patent:
**17.11.82 Bulletin 82/46**

(84) Designated Contracting States:
**CH DE FR GB SE**

(56) References cited:
**DE - A - 2 729 030**
**DE - A - 2 746 778**
**DE - B - 2 459 663**
**US - A - 3 588 777**
**US - A - 3 837 907**

**APPLIED PHYSICS LETTERS, Volume 32, Nr. 3,
February 1978, New York, J. T. C. YEH et al.
"Light-induced superconducting weak links"
pages 191 to 192**

(73) Proprietor: **SPERRY CORPORATION**
**1290, Avenue of the Americas**
**New York, N.Y. 10019 (US)**

(72) Inventor: **Jillie, Don Warren, Jr.**
**226, Cedar Avenue**
**Arlington Massachusetts 02174 (US)**

(74) Representative: **Michaels, Peter Albert**
**SPERRY UNIVAC Patent & Licensing Services**
**M.S. S2 W1 SPERRY UNIVAC CENTRE**
**London NW10 8LS (GB)**

(56) References cited:
**IBM Technical Disclosure Bulletin, Volume 17,
Nr. 9, February 1975 New York, E. P. HARRIS et
al. "Production of weak links in superconducting
thin films by ion implantation" pages 2793 to
2794**

Courier Press, Leamington Spa, England.

## Method of making interlayer electrical connections in a multilayer electrical device

The invention relates to a method of making a layered electrical device having a very small interconnection between two conducting layers through a small hole in an intervening insulating layer.

Conventional methods generally practised in the art for fabricating subminiature diameter holes in thin insulating films are generally based upon chemically etching the holes through a photoresist mask; however, the utility of conventional photoresist techniques for the purpose is generally limited to dimensions of one micron or greater.

Electron beam lithographic techniques have been employed for producing masks for generating small holes; however, if chemical (wet) etching is used with such a mask, severe undercutting of the material just below the mask results and there is no fully effective control over the diametric dimension of the bore.

It has been suggested that conventional plasma or ion milling etching (dry etching) methods should be employed to minimise undercutting, but typical resist materials are rapidly destroyed by heat or when exposed to the reactive gas environments used with these latter two methods, so that an acceptable product is not reliably generated and/or is correspondingly expensive.

Multiple weak link superconductor devices have been successfully made using standard electron resist techniques to generate mask patterns and to etch micron holes in a silicon dioxide layer. The use of such techniques has demonstrated the need for a more reliable method for generating such holes. It has been suggested that smaller holes of more predictable size can be made by employing electron beam lithography techniques similar to electron beam machining or mask making, but such techniques are difficult to reproduce and require expensive capital equipment. Accordingly, a reliable, easily repeatable, and inexpensive method is desired, since the superconductor devices involved have wide possibilities for competitive use in commercial signal processors and computers, and it is an object of the invention to provide such a method.

The invention comprises a method of making a layered electrical device including two conducting layers separated by an insulating layer and in which a hole for connection between the layers is etched through the insulating layer and in which the insulated layer is deposited on the first conducting layer as two successive layers, the first layer being resistant to a first etching process but etchable by a second etching process, the second layer being etchable by the first etching process but resistant to the second etching process, a mask is applied to the second layer to define the position of the required hole, the hole is etched in the second layer by the first etching process and is then etched in the first layer by the second process during which step the second layer acts as hole defining mask, and conducting material is deposited on the insulator to form the second conducting layer and the connection through the hole.

The invention is applicable, in particular, to multiple weak link superconductor devices of the general kind described in our pending German Patent Application No. P 28 40 525.6 filed 18 September 1978 and due to be published in March 1979. A copy of that application is annexed to the present application.

The method of the invention will now be described with reference to the manufacture of such a device, and referring to the accompanying drawings, in which

Figure 1 is a plan view of a superconductive device.

Figure 2 is a cross-section of a portion of the device of Figure 1 taken along the line 2—2.

Figure 3 is a more detailed cross-section corresponding to Figure 2.

Figure 4 is a graph of the current-voltage characteristic of the device of Figures 1, 2, and 3.

Figures 5, 6, and 7 are cross-sections of portions of the device of Figure 3 showing steps in the process of its manufacture.

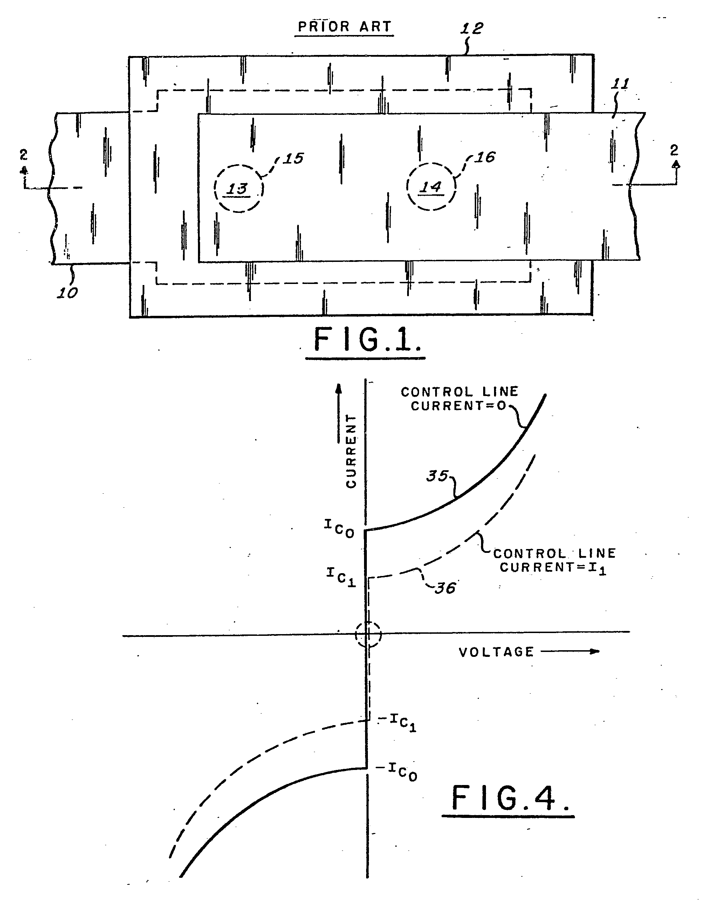

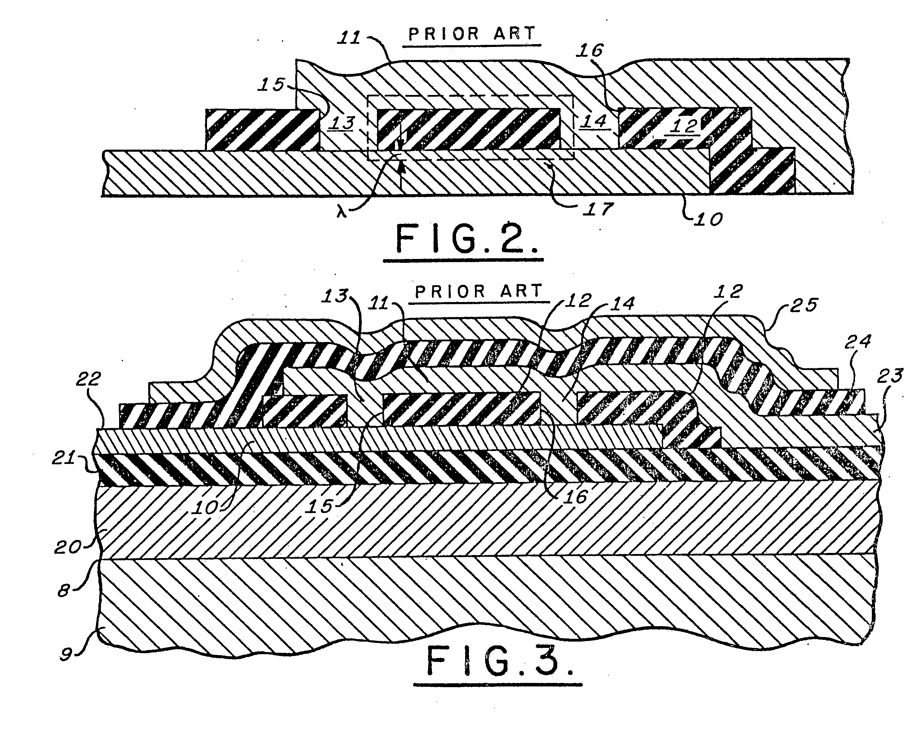

The invention will be described in its application to the multiple weak link superconducting quantum interference device (SQUID) described in the German patent application No. P 28 40 525.6 referred to above, features of which are illustrated in the plan and cross-section of Figures 1 and 2. It comprises a lower layer 10 and a similar superimposed layer 11 of superconductive material, preferably of a refractory metal such as niobium, between which layers is an electrically insulative layer 12. In one embodiment the insulative layer 12 is a deposited layer of silicon dioxide approximately 300 nm (3,000 Angstrom units) thick, but deposited insulators of other thicknesses may be used. For example, sputtered silicon or germanium may be used as the cryogenic insulators if the insulating layer is sufficiently thick to prevent electrical conduction. Silicon layers of thickness between 100 and 300 nm (1,000 and 3,000 Angstrom units) have been used. Chemically vapour deposited layers of glass may also be used, as well as evaporated layers of silicon monoxide. Preferably, the insulative layer 12 is so constituted as not to support significant Josephson tunnelling.

In accordance with the invention described in the above-numbered German patent application, two weak links 13 and 14 are included, coupling the lower superconductive layer 10 to the upper superconductive layer 11. The weak links 13 and 14 are formed by very small diameter holes 15 and 16 through the insulative layer 12 filled with superconductive material when the superconductive layer 11 is deposited over the insulative layer 12. The holes 15 and 16 may have diameters of about one micron. It will be appreciated that more than two weak links may be provided through the insulative layer 12, and also that the dimension of one micron is exemplary, other dimensions being useable in supporting weak link properties, the main criterion in this application being that the length and width are approximately equal to, or less than, the conventional superconducting coherence length.

A region 17 is illustrated which is generally bounded as shown in dotted lines by the weak links 13 and 14 and the surfaces of the upper and lower superconductive layers 10 and 11 adjacent to the insulative layer 12. The total effective region is defined in accordance with the depth of penetration of magnetic fields into the superconductive material, which depth of penetration is given by the conventional London penetration depth $\lambda$. Control of the critical current through the SQUID from the layer 10 to the layer 11 is provided by the magnetic flux that threads the region 17.

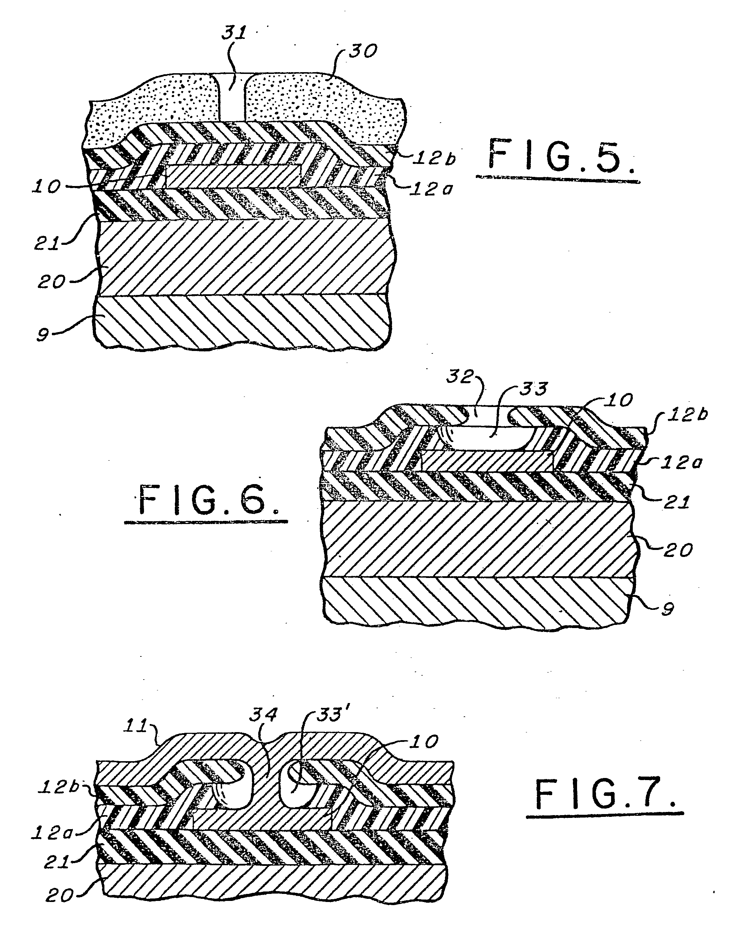

Referring to Figure 3, in which like reference numerals indicate like components with respect to Figures 1 and 2, a more detailed and complete cross-section of the SQUID of Figures 1 and 2 is illustrated. As is known by those skilled in the art, superconductive Josephson logic and memory circuits are generally planar devices with their elements deposited on a superconductive microwave ground plane with the superconductive lines of the device forming microwave strip transmission lines. Accordingly, the lower superconductive layer 10 of Figure 2 is shown in Figure 3 as having been deposited over a superconductive ground plane 20 from which it is separated by the microwave strip transmission line dielectric layer 21. The ground plane 20 is deposited on a substrate layer 9 of silicon having an oxidized surface 8. The ground plane 20 may be a sputtered layer of niobium 100 to 500 nm (1,000 to 5,000 Angstrom units) thick, deposited on the substrate surface 8, with the dielectric layer 21 consisting of sputtered silicon dioxide or amorphous silicon deposited on ground plane 20. Superconductive microwave strip extensions 22 and 23 of the superconductive layers 10 and 11, respectively, are deposited on the dielectric layer 21 and may form part of a superconductive Josephson logic or memory circuit in which the SQUID is utilized as an active switch.

A further insulator layer 24 deposited over the superconductive layer 11 electrically insulates a control line 25 from the layer 11.

The control line 25 is a superconductive strip disposed parallel to the strips 10 and 11, at least in the region of the weak links 13 and 14. In a practical circuit, it is to be understood that the control line 25 should not actually run superposed over the extensions 22 and 23, so as not to disrupt their microwave transmission line properties. Current flowing through the control line 25 generates a magnetic field resulting in a control flux threading the region 17 (Figure 2), thus providing control of the current through the weak links 13 and 14. The superconductive ground plane 20 confines the magnetic fields produced by current flowing in the microwave strips 10 and 11 to the same side of ground plane 20 as the sources of the fields, and so increases the coupling of the magnetic field generated by the control line 25 to the SQUID. The planes containing the upper and lower superconductive layers 11 and 10 are substantially parallel to the planes of the superconductive ground plane 20 and the control line 25, with the weak links 13 and 14 disposed substantially orthogonally to them.

In operation, current flowing between the lines 22 and 23 in the device of Figure 3 is controlled by the magnetic field through the SQUID generated by current through the control line 25. Figure 4 illustrates the current-voltage characteristics of the SQUID when the control line current is zero (curve 35) and when the control line current is equal to $I_l$ (curve 36). The current voltage characteristics of the SQUID may be derived by passing a variable current between the leads 22 and 23 and measuring the voltage between them for various values of direct current applied to control line 25. These characteristics may conveniently be displayed, for example, on an oscilloscope by applying an alternating current to the SQUID and a variable direct current to the control line 25. The critical current $I_c$ for zero control line current is $I_{c_0}$, whereas the critical current for the control line current $I_l$ is $I_{c_1}$. Thus, when the external magnetic field applied to the SQUID is zero, the value of the current through the SQUID is the critical current $I_{c_0}$. When a current $I_l$ is passed through the control line 25, the value of the current through the SQUID is the critical current $I_{c_1}$.

It will be appreciated that the device of Figure 3 exhibits maximum sensitivity of the critical current through the SQUID to the control current through the line 25. The plane which contains weak links 13 and 14 is substantially perpendicular to the planes which contain the ground plane 20 and the upper and lower superconductive layers 10 and 11 and the control line 25. Thus, the region 17 bounded by the weak links 13 and 14 and the planes coinciding with the London penetration depth $\lambda$ inside the upper and lower superconductors 10 and 11 will have a maximum projection against the direction of the magnetic field generated by control current flowing through line 25. The magnetic flux linking the SQUID for a given control line current will therefore be a maximum for this geometric arrangement, and, since the critical current depends upon magnetic flux rather than on the magnetic field itself, maximum sensitivity to the control current results. Additionally, the control sensitivity is maximum when the control current through the line 25 flows in the direction from 13 to 14 or vice versa, rather than at an angle to the plane of the drawing.

It is advantageous to maintain a high ratio of the maximum critical current to the minimum critical current that can be supported by the SQUID. This result is achieved by making the individual critical currents of the weak links 13 and 14 as nearly equal as possible, which is accomplished by making the individual weak-links as precisely alike as possible. Methods of obtaining almost identical weak links are known in the arts of depositing insulator films of substantially uniform thickness and of producing holes therein of relatively uniform cross-section by electron beam lithography as taught in the aforementioned German patent application. However, the present invention extends the ability of the practitioner even more precisely to control the dimension of weak links such as 13 and 14.

Referring again to Figure 3, the insulative layers 21 and 24 have a different function from that of the insulative layer 12. The layer 12 defines the weak links 13 and 14 of the active device and, as explained, the thickness of the layer 12 affects the sensitivity of the device to control by the applied magnetic field. The thickness of the layer 12 and its dielectric constant determines the lumped element equivalent capacitance of the device. The insulative layer 21 isolates the strip transmission lines 22 and 23, which are extensions of the upper and lower superconductors 10 and 11, and the extension of the control line 25, from the ground plane 20. The control line 25 cannot reside directly over the lines 22 and 23 except in the vicinity of the active SQUID device. The widths of the lines 22, 23, 25, and the thickness and dielectric constant of the insulator layer 21 determine the characteristic or surge impedance of the microwave strip transmission lines.

The method of fabrication of the superconductive device of Figure 3 may be initiated starting with steps generally similar to the initial steps described in the aforementioned German patent application. The initial steps of fabrication will first be discussed.

Construction is started by selecting a clear silicon wafer 9 on which the ground plane niobium layer 20, the silicon dioxide insulative layer 21, and the lower niobium layer 10 are successively affixed. The several layers may be generated successively within an evacuated radio-frequency sputtering vessel of conventional nature. Initial pressure is about 13 micro-Pa (about $10^{-7}$ Torr), the system being backfilled with argon at about 3 Pa (20 milli-Torr).

All the sputtering cathodes are cleaned of absorbed gases and other contaminants by pre-sputtering at low power (100 watts for 5 minutes), as is usual in the sputtering art. The niobium layer 20 is formed to a depth of about 400 nm (4,000 Angstrom units) on the silicon wafer 9 by sputtering for 20 minutes at 500 watts, the silicon dioxide dielectric layer 21 to a depth of about 400 nm (4,000 Angstrom units) by sputtering for 30 minutes at 200 watts and, finally, the niobium layer 10 to a depth of about 300 nm (3,000 Angstrom units) by sputtering for 15 minutes at 500 watts. During these steps the substrate 9 is water-cooled so that the temperature rise of the semiconductor materials due to the sputtering process is adequately controlled. It will be understood that these parametric values are typical of a particular sputtering system and will vary from system to system, depending upon the system design.

The lower niobium superconductor layer 10 is next treated by standard photoresistive procedures and by wet chemical, dry chemical, or sputter etching to form the illustrated island pattern and its extension 22. It is preferred according to the present invention that the island and extension 22 are patterned using a known positive photoresist material and a standard contact mask with conventional photoresist procedures. After the photoresist is developed, the niobium layer 10 is selectively etched away, preferably within a conventional plasma etching-stripping machine such as that generally illustrated in U.S. patent 3,795,557. Such machines generate a relatively high pressure reactive plasma in oxygen and selected halocarbon gases for etching various metals, with minimum removal of the developed organic photoresist mask and of the exposed silicon dioxide. According to the present method, the lower superconductor layer 10 is etched at about a 100-watt level in about two minutes. Since the silicon dioxide insulative layer 21 does not readily etch, it acts as a stop for the etching process.

Next, the developed photoresist is stripped from the niobium layer 10 by using a conventional organic chemical resist stripper or, preferably, by performing the operation in the same plasma machine, but with oxygen fully replacing the etchant halocarbon gas. Stripping may be accomplished at pressures of oxygen of about 700 Pa (about 5 Torr) at power levels at 400 to 500 watts for ten to fifteen minutes, the process removing all photoresist without significantly affecting the silicon dioxide or patterned niobium. The operations described are performed in the best known manner for providing a smooth, uniform, and flat upper surface for the niobium lower conductor 10 to aid in arriving at the desired dimensional precision of the structure remaining to be fabricated.

According to the invention, the insulating layer 12 of Figure 3 is next formed by generating the two component layers 12a and 12b shown in more detail in Figure 5, which a cross-section at right angles to the plane of the drawing of Figure 3. The layer 12a is formed to a thickness of 100 nm (1,000 Angstroms) by sputtering silicion dioxide for 15 minutes at a 200-watt level, after which the amorphous insulating layer 12b is formed of sputtered silicon with a depth of 100 nm (1,000 Angstroms) in 5 minutes at a 500-watt level. Well known sputtering procedures may be used to form layers 12a and 12b. As in all sputtering steps, the substrate 9 is affixed in close thermal contact to a water-cooled platen in order to prevent damage due to over-heating.

The surface of silicon layer 12b is next coated with an electron beam resist layer 30 (Figure 5) formed of a material conventionally used for the purpose, such as polymethyl methacrylate. Conventional spin-coating is preferred so as to obtain a uniform film 30 of constant thickness over the superconductive layer 10 when the usual baking step is completed. After baking, the surface of the methacrylate layer above the future location of the weak link connection is exposed to a finely-focussed electron beam. The electron beam resist layer 30 is then developed, using the conventional procedure, so that the small diameter region exposed to the electrons is removed. The structure shown in Figure 5 is thus completed, the major extent of the hole 31 having a regular diameter of 0.5 micrometres diameter; however, holes having very regular diameters of 0.2 micrometres are readily produced.

Next, to form the structure as it is shown in Figure 6, the configuration of Figure 5 is introduced into a conventional plasma etching machine, such as that used in a previous step, with a reactive gas of the type employing oxygen and a selected halocarbon gas or gases such as are sold as the proprietary gas DE—100 by the LFE Corporation, Waltham, Massachusetts. In this step, the silicon surface of the layer 12b exposed by the hole 31 is plasma-etched by a reactive electrically energized gaseous ion etching process for about 30 seconds at a gas pressure of 3 Torr and at a 100 watt power level. The reactive gas etches the silicon layer 12b, but has comparatively little effect on the silica layer 12a when it reaches it, or on the methacrylate resist layer 30. While there is some undercutting of the silicon layer 12b in the plasma etching step with respect to the diameter of the hole 31 in the resist, the undercutting is not severe, and is far less than when etching is attempted using wet chemical methods. While known phororesist materials may be used in place of the methacrylate, the latter is sufficiently rugged, lasting long enough under plasma bombardment to allow the etching of the desired hole through the silicon layer 12b. Typically, a 0.5 micrometer hole 31 results in a 0.7 micrometer average diameter hole through the silicon layer 12b, the silica layer 12a being substantially untouched.

Next, the reactive gas is swept from the plasma chamber and, using oxygen alone, the remaining resist is stripped in about four minutes by operation at about a 350-watt level. The device is then removed from the plasma chamber and is etched in buffered hydrofluoric acid for about one minute or for a time sufficient to etch through the silica layer 12a primarily where it has been uncovered by the hole 32 in the silicon layer 12b. Hydrofluoric acid is selected because it does not etch the niobium layer 10 or the silicon layer 12b to any significant extent; thus the hole 32 retains its shape and the niobium layer 10 is not attacked. It is to be observed that the silica layer 12a is undercut by the acid etch, but this is not of material consequence. The silicon layer 12b and the hole 32 through it remain intact and are not affected by the acid etch. The silicon layer 12b is to remain as a permanent insulating part of the structure, but also serves an immediate purpose as a mask for the next step.

In this next step, the upper niobium layer 11 is formed over the silicon layer 12b, along with the weak link connector 34 passing through the holes 32, 33 and making good electrical contact with the upper surface of the lower niobium layer 10. The structure shown in Figure 6 is etched by sputtering at about 100 watts for three minutes to clean all exposed surfaces, including the exposed upper surface of the niobium layer 10. This is followed by a 5 minute niobium pre-sputter episode at about 100 watts and then by about 30 minutes of sputtering niobium at about a 500 watt level. The resulting niobium layer 11 extends as shown in Figure 7 across the hole 32 and is about 600 nm (6,000 Angstroms) thick; it extends down into holes 32, 33 so as to form a circular cylindric weak link connector 34 making good contact with the lower niobium layer 10. While an annular empty space 33' at the layer 12a remains surrounding the weak link 34, the silicon layer 12b has served as a very effective mask and the hole 32 within it has served to ensure that weak link 34 is of uniform diameter and of repeatable dimensions.

Although the method of the invention is explained in relation to a superconductive device having one pair of weak links 13 and 14, it will be appreciated that more than two such weak links may be utilised, for example, weak links in excess of two may be utilised to alter the dependence of the critical current upon the control line current.

The line extensions 23 of Figure 3 are formed simultaneously with the niobium layer 11. To complete the device as shown in Figure 3, any unwanted portions of the niobium layer 11 are first removed by photoresistive and plasma etching procedures such as were used to pattern the niobium layer 10. The insulator layer 24 is then formed by sputtering 300 nm (3,000 Angstrom units) of silicon dioxide or by evaporating silicon monoxide.

Any unwanted areas of this insulator layer are removed by standard photoresistive and etching procedures. It is required that the crossover insulator layer 24 exist only between niobium layers 25 and 11 or 23 and between layers 25 and 10 or 22. The final step involves sputtering the upper niobium layer forming the control line 25. The layer deposited in this step can also form any required interconnections between the layers 22 and 23 with respect to portions of associated circuits whose exact nature must be dictated by the requirements of the system in which the device of Figure 3 is to be employed and which therefore are not necessarily concerned with the present invention.

Although the drawings are diagrammatic, and the proportions have been modified for clarity, it may be taken that they represent enlargements of roughly 20,000 times.

Plasma etching is a known reactive process in which fluorine and oxygen radicals appear to interact chemically with materials at a surface during etching. Conventional ion beam etching, including ion beam or sputter etching methods using reactive gases such as oxygen and fluorocarbons, may be sucessfully substituted in any of the foregoing steps for plasma etching.

The invention thus provides a novel method for forming microscopic submicron diameter bores in thin insulative films such as employed, for example, in superconductive and other current control devices. The method also permits the formation of holes through insulative layers of thickness greater than the diameter of the bore. The method permits the successful formation of such very small holes in dual component layers by selecting the components of distinct materials, one component layer being preferably relatively thick while the other is thinner. The upper or thin layer is patterned by use of plasma or ion beam (dry) etching through an electron-beam generated hole in a temporary mask. The insulative material of the lower component layer acts as a stop for the dry etching process, but is capable of being chemically (wet) etched. The upper component layer is readily dry etched, but is resistant to chemical (wet) etching. The upper component layer serves as a permanent mask to define the narrow dimension of the bore and, more important, the diameter of a connecting link subsequently formed within the bore. While initially serving as a masking pattern, the first component layer remains in the structure to form an integral part of the insulative structure.

## Claims

1. A method of making a layered electrical device including two conducting layers (10, 11) separated by an insulating layer (12) and in which a hole (13, 14) for a connection between the layers is etched through the insulating layer (12) characterised in that the insulating layer (12) is deposited on the first conducting layer (11) as two successive layers (12a, 12b), the first layer (12a) being resistant to a first etching process, but etchable by a second etching process, the second layer (12b) being etchable by the first etching process, but resistant to the second etching process, a mask (30) is applied to the second layer (12b) to define the position of the required hole (31), the hole (32) is etched in the second layer by the first etching process and is then etched (33) in the first layer by the second process, during which step the second layer acts as a hole defining mask, and conducting material is deposited on the insulator to form the second conducting layer (11) and the connection (34) through the hole, the first etching process being such as to be capable of generating a hole of diameter of the order of 0.5 micrometers without severe undercutting.

2. A method according to claim 1 in which the second etching process is a wet etch, and the first etching process is a reactive electrically-energised gaseous ion etching process.

3. A method according to claim 2 in which the first insulative layer is of silica and the wet etching process is a hydrofluoric acid etch.

4. A process according to claim 2 or claim 3 in which the second insulating layer is of silicon.

5. A method according to any preceding claim in which the total thickness of the layers is large in relation to the hole diameter and the second insulating layer is thinner than the first insulating layer.

6. A method according to any preceding claim in which the conducting layers and the interconnection are of superconductive material.

7. A method according to claim 6 in which the superconductive material is niobium.

## Patentansprüche

1. Verfahren zum Herstellen eines aufgeschichteten elektrischen Gerätes mit zwei durch eine isolierende Schicht (12) getrennten leitenden Schichten (10, 11), bei dem durch die isolierende Schicht (12) ein Loch (13, 14) für eine Verbindung zwischen den Schichten geätzt wird, dadurch gekennzeichnet, daß die isolierende Schicht (12) auf der ersten leitenden Schicht (11) in Form zweier aufeinanderfolgender Schichten (12a, 12b) niedergeschlagen wird, von denen die erste (12a) bei einem ersten Ätzverfahren widerstandsfähig, aber bei einem zweiten Ätzverfahren ätzbar ist und die zweite (12b) bei dem ersten Ätzverfahren ätzbar, aber bei dem zweiten Ätzverfahren widerstandsfähig ist, daß zur Festlegung des Ortes des erforderlichen Loches (31) eine Blende (30) auf die zweite Schicht (12b) aufgebracht wird, daß bei dem ersten Ätzverfahren das Loch (32) in die zweite Schicht und dann bei dem zweiten Ätzverfahren das Loch (33) in die erste Schicht geätzt wird, während die zweite Schicht als das Loch festlegende Blende wirkt, und daß ein leitendes Material auf dem Isolator zur Bildung der zweiten leitenden Schicht (11) und der Verbindung (34) durch das Loch niedergeschlagen wird, wobei das erste Ätzverfahren derart abläuft, daß ein Loch von einem Durchmesser in der Größenordnung von 0,5 $\mu$m ohne eine starke Unterhöhlung erzeugt werden kann.

2. Verfahren nach dem Anspruch 1, bei dem das zweite Ätzverfahren eine nasse Atzung und das erste Ätzverfahren ein durch elektrischen Strom bedingtes, gasförmiges Ionenreaktions-Ätzverfahren ist.

3. Verfahren nach dem Anspruch 2, bei dem die erste isolierende Schicht aus Siliciumdioxid besteht und das nasse Ätzverfahren eine Flußsäureätzung ist.

4. Verfahren nach dem Anspruch 2 oder dem Anspruch 3, bei dem die zweite isolierende Schicht aus Silicium besteht.

5. Verfahren nach einem vorhergehenden Anspruch, bei dem die Gesamtdicke der Schichten groß in bezug auf den Lochdurchmesser ist und die zweite isolierende Schicht dünner als die erste isolierende Schicht ist.

6. Verfahren nach einem vorhergehenden Anspruch, bei dem die leitenden Schichten und die Zwischenverbindung aus einem supraleitenden Material bestehen.

7. Verfahren nach dem Anspruch 6, bei dem das supraleitende Material Niob ist.

**Revendications**

1. Procédé pour réaliser un dispositif électrique multi-couches comprenant deux couches conductrices (10, 11) séparées par une couche isolante (12) et dans lequel un trou (13, 14) est percé par décapage à travers la couche isolante (12) pour établir une connexion entre les couches, caractérisé en ce que la couche isolante (12) est déposée sur la première couche conductrice (11) sous la forme de deux couches successives (12a, 12b), la première couche (12a) étant résistante à un premier processus de décapage, mais pouvant être décapée par un second processus de décapage, alors que la seconde couche (12b) peut être décapée par le premier processus de décapage, mais est résistante au second processus de décapage, en ce qu'un masque (30) est appliqué sur la seconde couche (12b) pour définir la position du trou voulu (31), en ce que le trou (32) est percé dans la seconde couche par le premier processus de décapage, puis est percé (33) dans la première couche par le second processus de décapage, la seconde couche agissant pendant cette étape comme un masque définissant le trou, et en ce qu'une matière conductrice est déposée sur l'isolant pour former la seconde couche conductrice (11) et la connexion (34) à travers le trou, le premier processus de décapage étant tel qu'il permet de produire un trou ayant un diamètre de l'ordre de 0,5 micron sans creusement sévère.

2. Procédé selon la revendication 1 dans lequel le second processus de décapage est un processus au mouillé et le premier processus de décapage est un processus ionique gazeux réactif à excitation électrique.

3. Procédé selon la revendication 2 dans lequel la première couche isolante est une couche de silice et le processus de décapage au mouillé est effectué à l'aide d'acide fluorhydrique.

4. Procédé selon la revendication 2 ou 3, dans lequel la seconde couche isolante est en silicium.

5. Procédé selon l'une quelconque des revendications précédentes dans lequel l'épaisseur totale des couches est grande par rapport au diamètre du trou et la seconde couche isolante est plus mince que la première couche isolante.

6. Procédé selon l'une quelconque des revendications précédentes, dans lequel les couches conductrices et l'interconnexion sont en une matière supraconductrice.

7. Procédé selon la revendication 6, dans lequel la matière supraconductrice est du niobium.

PRIOR ART

# FIG.1.

CONTROL LINE
CURRENT=0

CURRENT

VOLTAGE ⟶

CONTROL LINE
CURRENT=$I_1$

# FIG.4.

PRIOR ART

FIG.2.

PRIOR ART

FIG.3.

FIG.5.

FIG.6.

FIG.7.